# EUROPÄISCHE PATENTSCHRIFT

(11) **EP 2 856 498 B1**
(45) Veröffentlichungstag und Bekanntmachung des Hinweises auf die Patenterteilung: **14.11.2018**
(21) Anmeldenummer: 13727130.0
(22) Anmeldetag: 03.06.2013
(51) Int. Cl.: H01L 21/67, H01L 21/673, C23C 14/50, C23C 14/56

(54) **SUSZEPTOR**
SUSCEPTOR
SUSCEPTEUR

(30) Priorität: 01.06.2012 DE 102012209278
(43) Veröffentlichungstag der Anmeldung: 08.04.2015
(73) Patentinhaber: KGT Graphit Technologie GmbH, 53578 Windhagen (DE)
(72) Erfinder: KORNMEYER, Torsten, 53639 Königswinter (DE); WISSKIRCHEN, Meinhard, 53359 Rheinbach (DE); STILL, Steffen, 50672 Köln (DE)
(74) Vertreter: Lippert Stachow Dresden
(86) Internationale Anmeldenummer: PCT/EP2013/061384
(87) Internationale Veröffentlichungsnummer: WO 2013/178824

(56) Entgegenhaltungen:
- JP-A- H01 123 991
- JP-A- S56 155 528
- US-A- 5 912 080
- US-A1- 2002 017 013
- US-A1- 2007 128 569

## Beschreibung

Die Erfindung betrifft einen Suszeptor aus Graphit oder CFC für den Prozessraum von Schutzgas- und Vakuum-Hochtemperatur-Prozessanlagen, der tunnelähnlich ausgebildet ist und an seinen beiden Enden jeweils mit einem Deckel verschließbar ist.

Unter Suszeptoren werden Bauteile verstanden, die sich im unmittelbaren Prozessbereich befinden und entweder zur Aufnahme der zu behandelnden Gegenstände dienen, oder diese in Form einer Kammer umgeben, so dass der Prozessraum weitgehend abgeschottet ist.

Die Suszeptoren ruhen auf einer Tragekonstruktion, die ebenfalls aus Graphit oder CFC (CFC: **C**arbon**f**aser **C**omposites besteht. CFC-Werkstoffe sind Carbonfaser-Verbundwerkstoffe für Hochtemperaturanwendungen) z.B. in einem Ofen. Die Suszeptoren werden an beiden Enden durch einen Graphitdeckel verschlossen, die zumeist an den Ofentüren angehängt sind und 0somit einfach geöffnet und geschlossen werden können. Für Hochtemperaturprozesse sind um den Suszeptor Heizelemente, zumeist Stabheizelemente, in gleichmäßigem Abstand zueinander angeordnet.

Ein Beispiel für einen profilierten Suszeptor zur Aufnahme von Halbleiterwafern in einer Thermomogrationsanlage geht aus der EP 1 590 510 B1 hervor. Ein weiteres Beispiel für einen Suszeptor mit Graphitelementen findet sich in der US 5 912 080 A.

Suszeptoren werden in Vakuumprozessanlagen eingesetzt, die zur Herstellung und Bearbeitung von Bauteilen aus technischer Keramik, Hartmetall und anderen Legierungen dienen, wobei die Bauteile durch einen Gasdruck sowie hohe Temperaturen beaufschlagt werden. Insbesondere dienen die Suszeptoren zur Abgrenzung des Prozessraumes gegenüber der Isolation oder anderen Ofenbauteilen, so dass diese vor übermäßiger Temperaturbelastung oder Belastung durch aggressive Gase geschützt sind.

Ein elementares Problem stellt die Wärmedehnung des Suszeptors im Prozessverlauf dar. Je nach Lage und Größe des Nutztraumes kann ein Suszeptor nicht mehr aus einem Graphitblock gefertigt werden. Insbesondere wenn der Suszeptor im Querschnitt gesehen, einem abgeflachten Rohr entspricht, bzw. tunnelähnlich ausgebildet ist, führt das zu dem Problem, dass für die Fertigung der Bauteile gegebenenfalls unterschiedliche Rohblöcke oder sogar unterschiedliche Rohmaterialien verwendet werden müssen.

Das hat die negative Folge, dass die einzelnen Bauteile des Suszeptors Unterschiede hinsichtlich der Wärmedehnung aufweisen. Das hat wiederum zur Folge, dass die Haltbarkeit der Bauteile eingeschränkt wird und dass der Suszeptor gegenüber dem übrigen Ofenraum undicht wird. Dadurch wird die Performance der Prozessanlagen verschlechtert und die Flexibilität in den Prozessparametern stark eingeschränkt.

Ein weiteres Problem ergibt sich bei der Verwendung ganzer Rohblöcke für abgeflachte Rohre (Suszeptoren) durch den erheblichen Materialverbrauch, da große Kerne anfallen. Da große Rohblöcke zumeist im Kern nicht so gut verdichtet sind, sind die ausgeschnittenen Kerne bzw. das Restmaterial nicht uneingeschränkt für andere Anwendungen verwendbar.

Der Erfindung liegt nun die Aufgabe zugrunde, einen flexibel modular ausbaubaren Suszeptor zu schaffen, der einen Material sparenden Aufbau besitzt und insbesondere eine gleichmäßige Wärmedehnung aufweist.

Die der Erfindung zugrunde liegende Aufgabe wird bei einem Suszeptor der eingangs genannten Art dadurch gelöst, dass dieser aus einer Mehrzahl von längs zu einem durchgehenden Tunnel aneinander gereihten Modulen besteht, dass jedes Modul aus einem Rohrabschnitt und einer daran befestigten Bodenplatte besteht und dass die Stirnflächen zwischen jeweils zwei Modulen formschlüssig miteinander verbunden sind.

Der Vorteil der Erfindung besteht einerseits darin, dass Suszeptoren mit beliebiger Länge zusammengebaut werden können und dass die einzelnen Module aus kleinstmöglichen Rohlingen gefertigt werden können, die wiederum eine hohe Homogenität über das Volumen verteilt aufweisen, so dass die daraus gefertigten Module die höchst mögliche Qualität aufweisen.

Um besonders stabile Module zu erhalten, ist es erfindungsgemäß vorgesehen, dass jeder Rohrabschnitt mit der zugehörigen Bodenplatte verschraubt ist.

In einer Fortführung der Erfindung erfolgt der Formschluss zwischen aneinander stoßenden Modulen mittels profilierter Stirnflächen, wobei eine Stirnfläche die Negativform der anderen Stirnfläche aufweist. Aufgrund der Profilierung der Stirnflächen besitzen diese eine größere Fläche, als ebene Stirnflächen, was eine gute Abdichtung zwischen benachbarten Modulen gewährleistet.

Ein noch besserer Formschluss zwischen zwei benachbarten Modulen wird erreicht, wenn zusätzlich oder alternativ zu den profilierten Stirnflächen in diesen Bohrungen eingebracht sind, in die Stifte zur formschlüssigen Verbindung benachbarter Module eingreifen.

In einer weiteren Ausgestaltung der Erfindung sind die Module zusätzlich form- und kraftschlüssig miteinander verbunden. Dazu sind die Bodenplatten benachbarter Module mit von Modul zu Modul übergreifenden Vertiefungen versehen, in die Verbindungselemente formschlüssig bündig eingreifen. Ein solches Verbindungselement kann ein Doppel-T-Feder-Nut Verbindungselement mit halbrundem Querschnitt sein.

Die Rohrabschnitte jedes Moduls können auch aus zwei oder mehr Segmenten bestehen, was ebenfalls den Vorteil der Verwendung kleinerer und homogenerer Rohlinge bringt. Schließlich können die aneinander reihbaren Module gleiche oder unterschiedliche Längen aufweisen, wodurch eine feine Abstufung der realisierbaren Länge des Suszeptors, verbunden mit einer Vereinfachung der Lagerhaltung, ermöglicht wird.

Erfindungsgemäß sind sämtliche Bauteile eines Moduls aus dem gleichen Rohling geschnitten, da auf diese Weise mögliche Unterschiede in der Wärmedehnung einzelner Bauteile vermieden werden, so dass die Module bei Temperaturbelastung nicht undicht werden.

Es ist weiterhin möglich, zwischen den Stirnflächen benachbarter Module ein Dichtmaterial einzubringen, hierzu eignen sich Folien- oder Graphitschnurdichtungen.

Weiterhin können die Module auch durch Verkleben mit einem Graphitzement oder einem Graphitkleber fest miteinander verbunden werden.

Die Erfindung soll nachfolgend an Hand eines Ausführungsbeispieles näher erläutert werden. In den zugehörigen Zeichnungen zeigen:
- Fig. 1:: einen aus einzelnen Modulen zusammengesetzten Suszeptor mit abgeflachtem Rohrquerschnitt, bestehend aus mehreren Rohrstücken, die jeweils mit einer Bodenplatte versehen sind;
- Fig. 2:: eine vergrößerte perspektivische Darstellung eines Teiles eines Suszeptors;
- Fig. 3:: einen Abschnitt eines Suszeptors; und
- Fig. 4:: ein Verbindungselement für eine Nut-Feder-Verbindung.

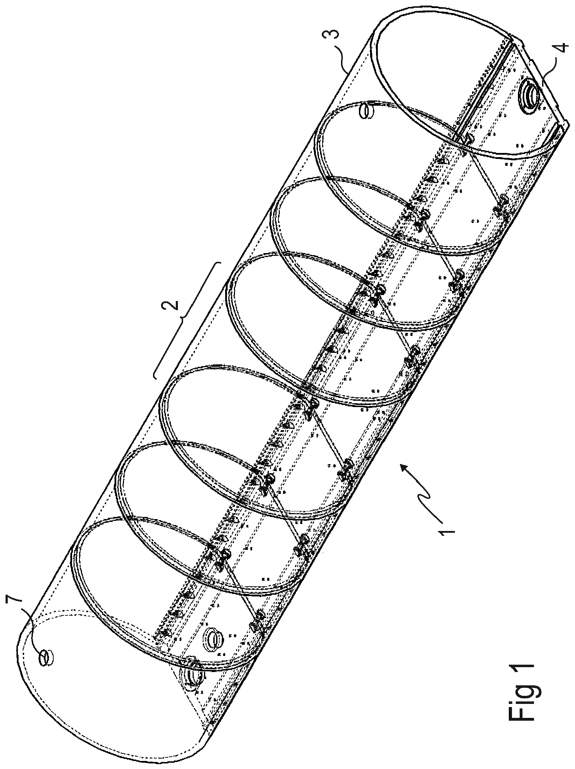

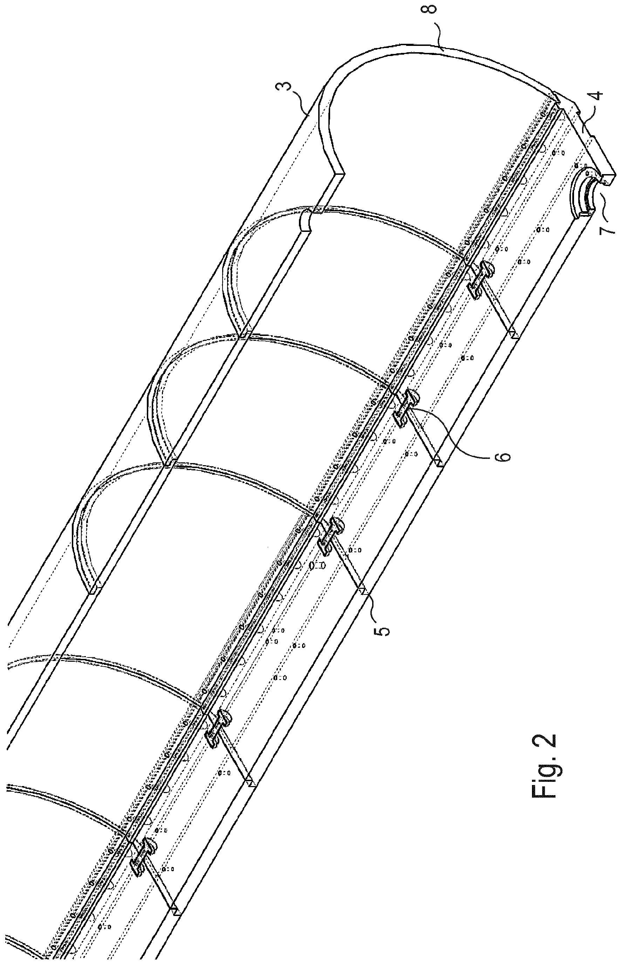

Fig. 1 zeigt einen aus einzelnen Modulen 2 zusammengesetzten Suszeptor 1 mit abgeflachtem Rohrquerschnitt, wobei jedes Modul 2 aus einem Rohrabschnitt 3 besteht, der mit einer Bodenplatte 4 versehen ist. Die Bodenplatte 4 ist mit dem Rohrabschnitt 3 verschraubt. Die Stirnflächen 5 zwischen zwei Modulen sind profiliert (Fig. 2), so dass die Bauteile durch eine Passung formschlüssig zusammengefügt werden können. Die Stirnflächen können beispielsweise so gestaltet werden, dass eine Stirnfläche 5 die Negativform der gegenüber liegenden Stirnfläche aufweist. Dadurch wird ein guter Formschluss erreicht und zugleich wird die Kontaktfläche zwischen den Stirnflächen 5 vergrößert, woraus eine bessere Abdichtung resultiert.

Alternativ oder zusätzlich können in den Stirnseiten Bohrungen vorgesehen sein, in die Stifte zur formschlüssigen Verbindung benachbarter Module eingreifen. Die Stifte bestehen ebenfalls aus Graphit oder CFC.

Um einen guten Verschluss der Enden des Suszeptors 1 mit jeweils einem nicht dargestellten Graphitdeckel zu gewährleisten, können die äußeren Stirnflächen 8 glatt ausgeführt sein (Fig. 2), oder ein zusätzliches Dichtelement aufweisen.

Wegen der nicht zu vernachlässigenden Wärmedehnung der Suszeptoren 1 sollten die Graphitdeckel beweglich oder federbelastet beweglich, z.B. an einer Ofentür, aufgehängt sein.

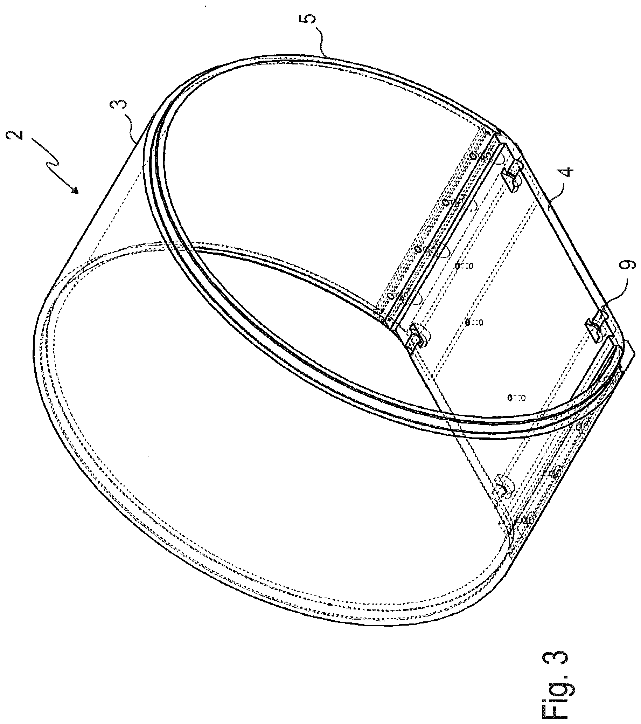

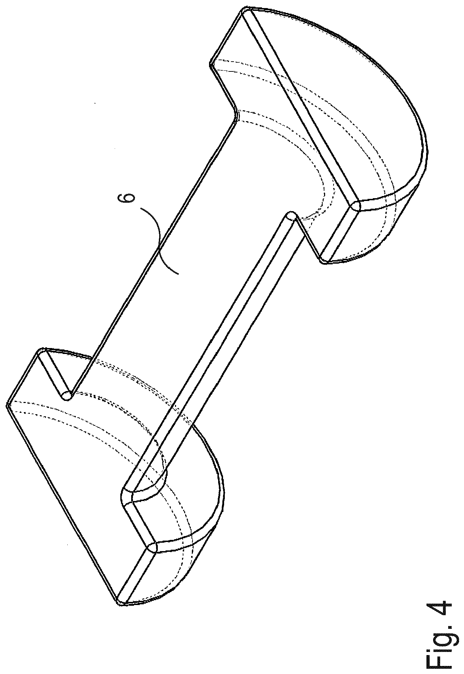

Weiterhin können kraft- und formschlüssige Verbindungselemente 6 (Fig. 4) zur festen Verbindung der Module 2 miteinander vorgesehen sein, die in entsprechende Vertiefungen 9 in den Bodenplatten 4 bündig eingreifen (Fig. 3). Fig. 4 zeigt ein derartiges Verbindungselement 6 in Form eines Doppel-T-Feder-Nut Verbindungselementes mit halbrundem Querschnitt.

Zusätzlich kann die Dichtigkeit der Fügestellen durch Einbringen von Folien- oder Graphitschnurdichtungen, oder auch durch Verkleben mit einem Graphitzement oder einem Graphitkleber erhöht werden. Damit wird zugleich erreicht, dass sich der Suszeptor insgesamt wie ein einstückig gefertigter Suszeptor verhält. Sämtliche Bauteile des Suszeptors 1 bestehen aus Graphit oder CFC.

Werden die Suszeptoren 1 aus Modulen 2 mit unterschiedlicher Breite zusammengesetzt, lassen sich auf einfache Weise, eine Vielzahl unterschiedlicher Rohrlängen des Suszeptors realisieren. Damit genügt es, für die Fertigung der Suszeptoren 1 eine gewisse Anzahl unterschiedlich breiter Module 2 zu bevorraten und es kann dennoch schnell auf unterschiedliche Kundenwünsche reagiert werden. Dadurch wird die Lagerhaltung ganz wesentlich vereinfacht.

Insbesondere bei größeren Suszeptoren kann es von Vorteil sein, wenn die Rohrabschnitte 3 in mehrere Segmente 10 aufgeteilt werden (Fig. 3). Das hat den Vorteil, dass aus vergleichsweise kleinen Rohlingen Suszeptoren mit großem Innenraum gefertigt werden können. Auch hier sind profilierte Stirnflächen vorgesehen, um die Einzelteile formschlüssig miteinander verbinden zu können. Zusätzlich ist es auch möglich, die Stirnflächen kraftschlüssig miteinander zu verbinden, was mit den beschriebenen Verbindungselementen 6 realisiert werden kann.

Auf jeden Fall sollte die Größe der Einzelteile eines Moduls 2 so gewählt werden, dass diese aus dem gleichen Rohling gefertigt werden können. Dadurch wird gewährleistet, dass die Wärmedehnung für Einzelteile eines jeden Moduls 2 gleich ist und somit sichergestellt, dass sich der gesamte Suszeptor 1 gleichmäßig in der Länge ausdehnt. Damit wird die Dichtigkeit der Fügestellen und der Stirnflächen zu den Türen bzw. Deckeln jederzeit gewährleistet.

Zusätzlich können in einigen Modulen 2 Ver- und Entsorgungsöffnungen 7 für Medien vorgesehen sein. Aus Fig. 1 ist ersichtlich, dass die jeweils äußeren Module 2 mit derartigen Öffnungen 7 versehen sind.

Selbstverständlich können auch Suszeptoren 1 mit anderen Querschnittsformen, z.B. auch rechteckig, auf die gleiche Weise, wie vorstehend beschrieben, zusammengesetzt werden.

Durch die Erfindung wird ein flexibler, modularer und Material sparender Aufbau von Suszeptoren 1 gewährleistet.

### Bezugszeichenliste

- 1: Suszeptor
- 2: Modul
- 3: Rohrabschnitt
- 4: Bodenplatte
- 5: Stirnfläche
- 6: Verbindungselement
- 7: Ver- und Entsorgungsöffnung
- 8: Stirnfläche
- 9: Vertiefung
- 10: Segment

## Patentansprüche

1. Suszeptor aus Graphit oder CFC für den Prozessraum von Schutzgas- und Vakuum-Hochtemperatur-Prozessanlagen, der tunnelähnlich ausgebildet ist, wobei der Suszeptor (1) aus einer Mehrzahl von längs zu einem durchgehenden Tunnel aneinander gereihten Modulen (2) besteht, die form- und kraftschlüssig fest miteinander verbunden sind, wobei die Stirnflächen (5) zwischen jeweils zwei Modulen (2) formschlüssig miteinander verbunden sind, **dadurch gekennzeichnet, dass** der Suszeptor an seinen beiden Enden jeweils mit einem Deckel verschließbar ist, jedes Modul (2) aus einem Rohrabschnitt (3) und einer damit verschraubten Bodenplatte (4) besteht und sämtliche Bauteile eines Moduls (2) aus dem gleichen Rohling geschnitten sind.

2. Suszeptor nach Anspruch 1, **dadurch gekennzeichnet, dass** der Formschluss zwischen benachbarten Modulen (2) mittels profilierter Stirnflächen (5) erfolgt, wobei eine Stirnfläche die Negativform der anderen Stirnfläche aufweist.

3. Suszeptor nach Anspruch 1 und 2, **dadurch gekennzeichnet, dass** der Formschluss zusätzlich oder alternativ zu den profilierten Stirnflächen (5) in den Stirnflächen (5) Bohrungen eingebracht sind, in die Stifte zur formschlüssigen Verbindung eingreifen.

4. Suszeptor nach Anspruch 1 bis 3, **dadurch gekennzeichnet, dass** die Bodenplatten (4) benachbarter Module (2) mit von Modul zu Modul übergreifenden Vertiefungen (9) versehen sind, in die Verbindungselemente (6) formschlüssig bündig eingreifen.

5. Suszeptor nach Anspruch 4, **dadurch gekennzeichnet, dass** das Verbindungselement (6) ein Doppel-T-Feder-Nut Verbindungselement mit halbrundem Querschnitt ist.

6. Suszeptor nach einem der Ansprüche 1 bis 5, **dadurch gekennzeichnet, dass** die Rohrabschnitte (3) jedes Moduls (2) aus zwei oder mehr Segmenten (10) bestehen.

7. Suszeptor nach einem der Ansprüche 1 bis 6, **dadurch gekennzeichnet, dass** die aneinander reihbaren Module (2) gleiche oder unterschiedliche Längen aufweisen.

8. Suszeptor nach einem der Ansprüche 1 bis 7, **dadurch gekennzeichnet, dass** zwischen den Stirnflächen (5) benachbarter Module (2) ein Dichtmaterial, wie Folien- oder Graphitschnurdichtungen eingebracht ist.

9. Suszeptor nach einem der Ansprüche 1 bis 8, **dadurch gekennzeichnet, dass** benachbarte Module (2) mit einem Graphitzement oder einem Graphitkleber fest miteinander verbunden sind.

## Claims

1. Susceptor made from graphite or CFC for the process space of protective-gas and vacuum high-temperature process installations, which is of tunnel-like design, wherein the susceptor (1) is composed of a plurality of modules (2) which are lined up with one another longitudinally into a continuous tunnel and which are firmly connected to one another positively and nonpositively, wherein the end faces (5) between two modules (2) in each case are connected to one another positively, **characterized in that** the susceptor can be closed at each of its two ends by means of a cover, each module (2) is composed of a tubular portion (3) and of a baseplate (4) screwed thereto, and all the components of a module (2) are cut from the same blank.

2. Susceptor according to Claim 1, **characterized in that** the positive connection between adjacent modules (2) is made by means of profiled end faces (5), one end face having the negative shape of the other end face.

3. Susceptor according to Claims 1 and 2, **characterized in that**, additionally or alternatively to the profiled end faces (5), in the end faces (5), bores are introduced, into which pins engage for the positive connection.

4. Susceptor according to Claims 1 to 3, **characterized in that** the baseplates (4) of adjacent modules (2) are provided with depressions (9) which pass over from module to module and into which connecting elements (6) engage, flush, in a positive manner.

5. Susceptor according to Claim 4, **characterized in that** the connecting element (6) is a double-T tongue-and-groove connecting element of semicircular cross section.

6. Susceptor according to one of Claims 1 to 5, **characterized in that** the tubular portions (3) of each module (2) are composed of two or more segments (10).

7. Susceptor according to one of Claims 1 to 6, **characterized in that** the modules (2) capable of being lined up with one another have identical or different lengths.

8. Susceptor according to one of Claims 1 to 7, **characterized in that** a sealing material, such as film or graphited cord seals, is introduced between the end faces (5) of adjacent modules (2).

9. Susceptor according to one of Claims 1 to 8, **characterized in that** adjacent modules (2) are connected firmly to one another by a graphite cement or graphite adhesive.

## Revendications

1. Suscepteur en graphite ou en CFC pour la chambre de processus d'installations de processus à haute température sous gaz protecteur ou sous vide, qui est conçu sous la forme d'un tunnel, le suscepteur (1) étant constitué d'une pluralité de modules (2) disposés côte à côte le long d'un tunnel traversant, qui sont solidement reliés les uns aux autres par complémentarité de forme et de force, les faces frontales (5) étant reliées les unes aux autres par complémentarité de forme entre chaque fois deux modules (2), **caractérisé en ce que** sur ses deux extrémités, le suscepteur peut se fermer chaque fois par un couvercle, **en ce que** chaque module (2) est constitué d'un tronçon tubulaire (3) et d'une plaque d'embase (4) vissée sur celui-ci et **en ce que** tous les éléments constitutifs d'un module (2) sont découpés dans la même ébauche.

2. Suscepteur selon la revendication 1, **caractérisé en ce que** la complémentarité de forme entre des modules (2) voisins s'effectue au moyen de faces frontales (5) profilées, une face frontale présentant la forme négative de l'autre face frontale.

3. Suscepteur selon la revendication 1 et 2, **caractérisé en ce qu'**en supplément ou en variante des faces frontales (5) profilées, pour la complémentarité de forme, des perçages sont ménagés dans la face frontale (5), dans lesquels des goujons s'engagent pour l'assemblage par complémentarité de forme.

4. Suscepteur selon la revendication 1 à 3, **caractérisé en ce que** les plaques d'embase (4) de modules voisins (2) sont munies de creux (9) débordants de module à module, dans lesquels des éléments d'assemblage (6) s'engagent à fleur, par complémentarité de forme.

5. Suscepteur selon la revendication 4, **caractérisé en ce que** l'élément d'assemblage (6) est un élément d'assemblage par rainure/languette en double T, à section transversale semi-circulaire.

6. Suscepteur selon l'une quelconque des revendications 1 à 5, **caractérisé en ce que** les tronçons tubulaires (3) de chaque module (2) sont constitués de deux ou de plusieurs segments (10).

7. Suscepteur selon l'une quelconque des revendications 1 à 6, **caractérisé en ce que** les modules (2) susceptibles d'être placés côte à côte présentent des longueurs identiques ou différentes.

8. Suscepteur selon l'une quelconque des revendications 1 à 7, **caractérisé en ce qu'**entre les faces frontales (5) de modules (2) voisins est introduite une matière d'étanchéité, comme des joints en film ou des joints en cordon de graphite.

9. Suscepteur selon l'une quelconque des revendications 1 à 8, **caractérisé en ce que** des modules (2) voisins sont solidement assemblés l'un à l'autre à l'aide d'un élément en graphite ou d'un adhésif en graphite.
